# EUROPEAN PATENT APPLICATION

(11) **EP 1 401 107 A1**
(43) Date of publication of application: **24.03.2004**
(21) Application number: 02021035.7
(22) Date of filing: 20.09.2002
(51) Int. Cl.: H03M 13/29, H03M 13/27

(54) **Method for improving the performance of 3-dimensional concatenated product codes**

(71) Applicant: SIEMENS AKTIENGESELLSCHAFT, 80333 München (DE)
(72) Inventor: Färbert, Andreas, Dr., 81825 München (DE); Stojanovic, Nebojsa, Dr., 80469 München (DE)

(57) **Abstract**

The method implies the steps of generating check bits (c) from information bits (a), which are represented by an information matrix, by an outer code,
shifting cyclically the information bits (a) and the check bits (c) to obtain an interleaved code matrix, and
than coding the bits of the interleaved code matrix by an inner code, where at least the outer code or the inner code is a product code.

## Description

The present invention relates to a method for of 3-dimensional concatenated product codes.

The capacity of optical transmission systems has rapidly increased in the last several years. The ability to upgrade a low bitrate system to a higher bitrate system by improving the optical components and compensating the limiting physical effects was the key for achieving system evolution.

The introduction of error control coding (ECC, FEC) was a very efficient tool that successfully improved the performance and reliability of digital data transmission. Adding redundancy check bits to the information bits and advanced decoding provides the possibility of increasing the transmission distance and further makes the system more robust to adverse conditions impairing transmission performance such as temperature variations and acoustic vibrations. Because of complexity reasons hard decoding is preferred to soft decoding. Codes like Bose-Chaudhuri-Hocquenghem codes (BCH) or extended BCH codes, which can be implemented easily, are preferred. To improve coding gain concatenated codes are used. But this group of codes is very sensitive when special error patterns are received. Those error patterns cannot be corrected and thus lead to an increase of the bit error rate (error flaring).

The basics of product coding are explained in "Prüfbare und korrigierbare Codes" W. Wesley Peterson, Oldenburg Verlag 1967, Seiten 117- 123.

Also 3-dimensional product codes can be used for further improvement. Each bit and therefore each error participates in three equations .

This invention refers to a method for improving the performance of 3-dimensional concatenated product codes and for the reduction of the error flaring.

The present invention provides a method for improving the bit error rate (BER) and therefore the coding gain according to claim 1. This is achieved by applying an encoding procedure, then interleaving the information bits and (at least a group of) check bits and finally applying an inner encoding procedure, whereby at least one of the codes is a with 3-dimensional product code. The best performance is gained with 3-dimensional outer product code, an interleaver according to this invention and an inner 3-dimensional outer product code.

The interleaver should be realizable with low design complexity and memory requirement.

Applying the described interleaving procedure both on columns and rows and regarding the first layer of a 3-dimensional code, it breaks the error bursts in rows and in columns of this layer.

If the interleaving is different in each of the layers having the same orientation even the "error burst" in the third dimension is broken.

Another advantageously interleaving method is the shifting of the parallel layers of the code matrix by different bits and than shifting the rows or columns by different numbers.

In order to achieve an easy implementable interleaver, for example the first column of a first layer of the 3-dimensional code remains unchanged and the elements (bits) of the following columns are cyclically shifted by one, two, three etc. positions, so that the elements of the first row are translated into diagonal elements by the interleaver. Then, after this first interleaving step, the positions of the elements of the first row remain unchanged and the elements of the following rows are shifted by one, two, three etc. positions.

For the following layer the position of the elements of the first row are shifted by one position and the elements of the following rows by 2, 3, 4 etc. positions (columns, rows and layers can be interchanged).

Another interleaving procedure start shifting the layers by 1, 2, 3, etc. positions and proceeds with shifting of rows or columns rectangular oriented to these layers by 0, 1, 2, 3 etc. positions.

For the three dimensional code a BCH-code with one or two error correction possibility is preferred.

The invention will became more apparent with reference to the following description along with the accompanying drawings.
Figure 1 schematic of a concatenated coding system;
Figure 2 schematic of a three-dimensional product code;
Figure 3 permanent error-pattern;
Figure 4 exemplary elements of a code matrix;
Figure 5 an example of a shift procedure;
Figure 6 exemplary elements of a code matrix and an interleaved code matrix according to this example;
Figure 7 exemplary elements of a code matrix and an interleaved code matrix;
Figure 8 a second example for an interleaved code matrix.

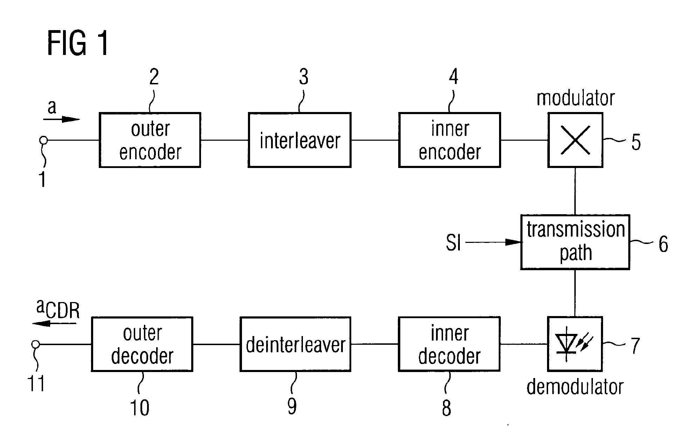

Figure 1 shows a schematic of a transmission system with a concatenated code implementation. The information bits "a" are fed to the input 1 of an outer encoder 2, which is the first element of a serial concatenation including an interleaver 3 and an inner encoder 4. At least one of the codes is supposed to be 3-dimensional product code, whereas the other code can be a 1- or 2-dimensional product code. But for an optimal success, the outer and the inner code should be 3-dimensional product code.

The information bits "a" and the generated check bits "c" are fed to a modulator 5, which converts the bits into physical signals "s" being transmitted over the transmission path 6 to a demodulator 7 at the receiving side. Because of the non ideal transmission path the signals are disturbed by signal impairments SI, e.g. external perturbations or physical effects of the transmission path. The demodulator 7 converts the received signals into (binary) bits "r", which are fed to a serial concatenation of an inner decoder 8, a deinterleaver (inverse interleaver) 9 and an outer decoder 10. The corrected information bits a_{COR} are emitted at the output 11.

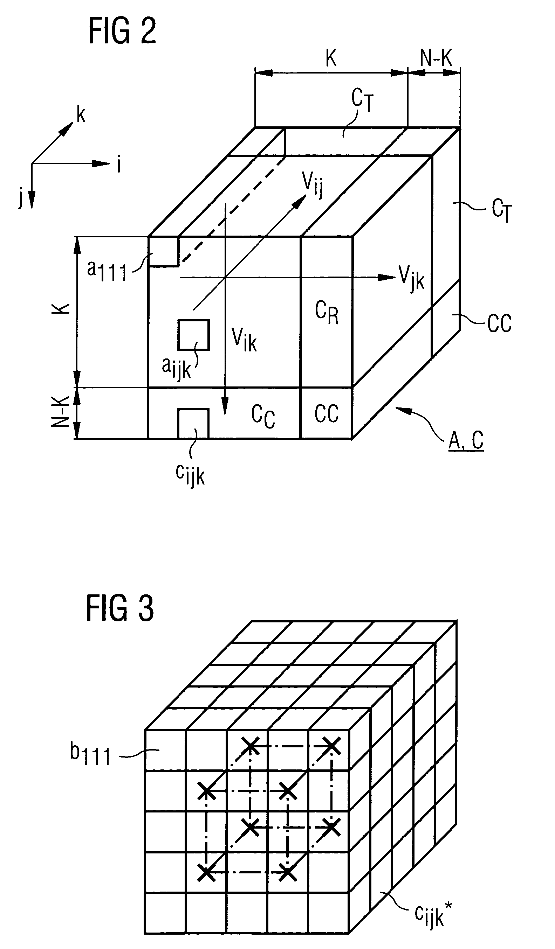

In **figure 2** a code matrix of a three-dimensional product code is shown, which may be generated by the outer encoder 2. The code matrix has the dimension of N × N × N bits and contains K × K × K information bits, the generated check bits C_{R}, C_{C} and C_{T} allow the correction of at least one error for each code vector (columns or row).

The information bits and the check bits form code vectors V_{i,j}; V_{i,k}; V_{j,k}, each code vector V_{i,j}; V_{i,k}; V_{j,k} containing a string of the adjoining information bits (a_{i,j,f(k)}; a_{i,f(j),k}; a_{f(i),j,k}) and adjoining check bits C_{T} = C_{i,j,f(k)}; C_{C} = c_{i,f(j),k;} C_{R} = c_{f(i),j,k}. For example, the code vector V_{j,k} contains the information bits a_{f(i),j,k}, where j, k = constant and for all i = 1 - K bits, and the checkbits C_{R} = c_{f(i),j,k} for i = (K+1) - N and j, k = constant.

Checks on check-bits CC can be used for checking the check-bits. Of course, also a non square code word matrix and also different codes can be used for rows and columns. The indices of the code elements, information and check bits, are consecutively numbered for each dimension.

In **figure 3** an example of a permanent 8-error-event for a product code with one-error-correcting codes as component codes is shown. In case of two errors in one row or one column a one-error-correcting code is overloaded and its decoder will, with high probability, add new errors. In the shown 8 error event also the product code will be overloaded because two errors occur in all relevant code vectors. Hence the errors will never be corrected by the product code alone, no matter how many iterations are used. The error pattern is permanent and leads to error flaring. For component codes that can correct two or more errors corresponding permanent error patterns exist.

However, such error patterns, which are permanent with regard to the product code alone, may be resolved in the overall concatenation thanks to the interleaver and the inner coding and decoding stages.

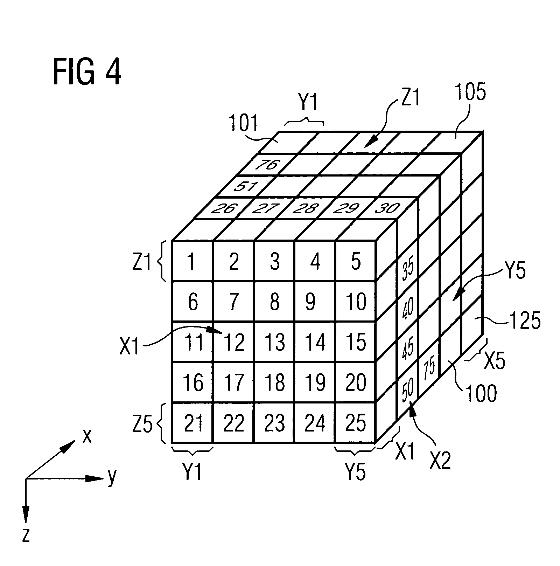

We consider the three dimensional product code word in **figure 4**. The code elements a, c are replaced by numbers, representing their original bit sequence. The front of the cube shows a first X-layer X1 (index k = 1, constant). The following layers (parallel slices) are numbered X2 - X5. The layers Y contains all code elements with an constant i, where i is 1 - 5, and the layer Z contains all code elements with an constant j, where j is 1 - 5.

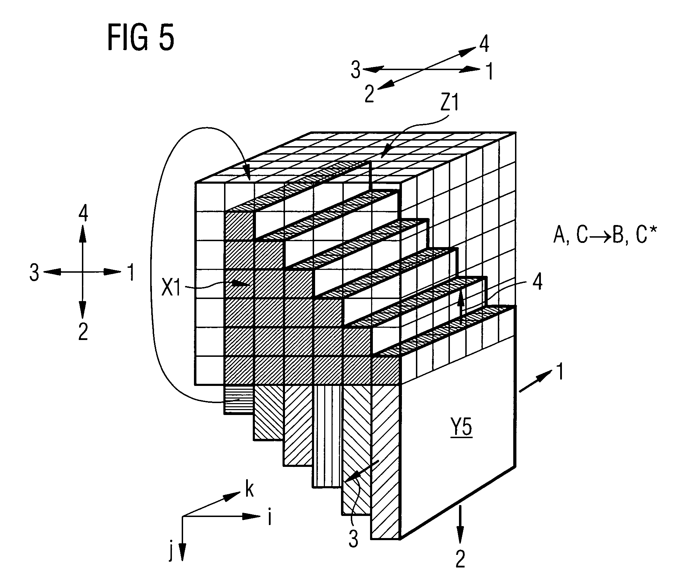

**Figure 5** shows one of the possible interleaving methods. The possible shift operations of code elements are described by letters X, Y, Z according to the layers and the directions for the shift of code elements or layers are indicated by ciphers 1 - 4. Regarding this first example for an interleaving process, the Y-layers (i-constant-layers) containing code elements with a constant index i for each layer are shifted by 0, 1 ,2 3 and 4 positions. Than the code elements shown in under the original code matrix are inserted in the upper part of the cube. In this example only the elements of all the i-rows (respective Z-layers) are interleaved while the columns in the j-direction direction still contain the same bits and the rows in the k-direction are unchanged.

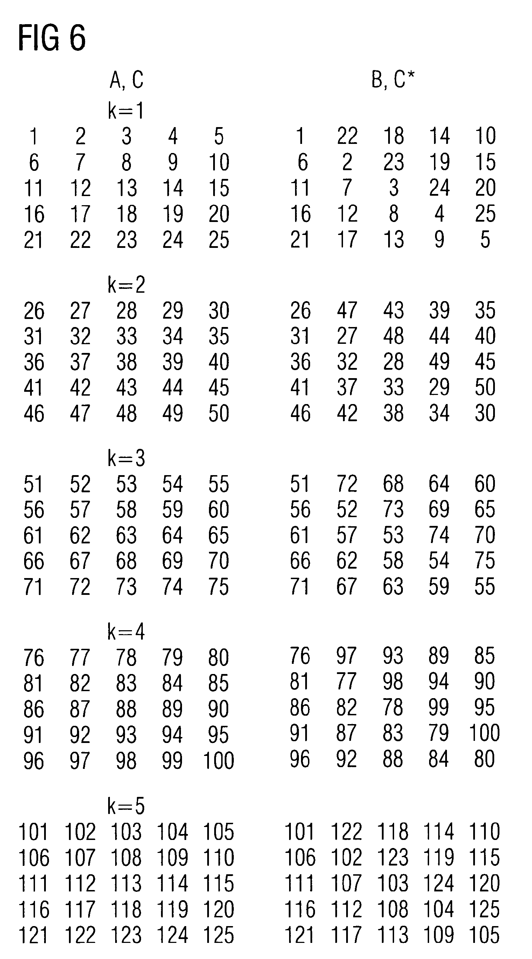

Figur 6 shows the elementary code elements before and after this shift operation in the form of a table. Each X-layer (k = 1, 2, 3, 4, 5) contains 25 numbers. Only the elements of the columns of all X-layers are shifted by the same numbers, respectively all Y-layers are shifted by 0, 1, 2, 3, 4 positions in the Y2 direction. So all rows of the X-layers and all (horizontal) rows of the Z-layers (respectively Y-layers) still contain the same bits. This interleaving is not very efficient. This interleaving procedure is helpful against burst errors but ineffective against the error pattern shown in figure 3.

An efficient interleaving procedure would shift the code elements different in each layer and add an additional shift procedure to interleave the code elements of the columns.

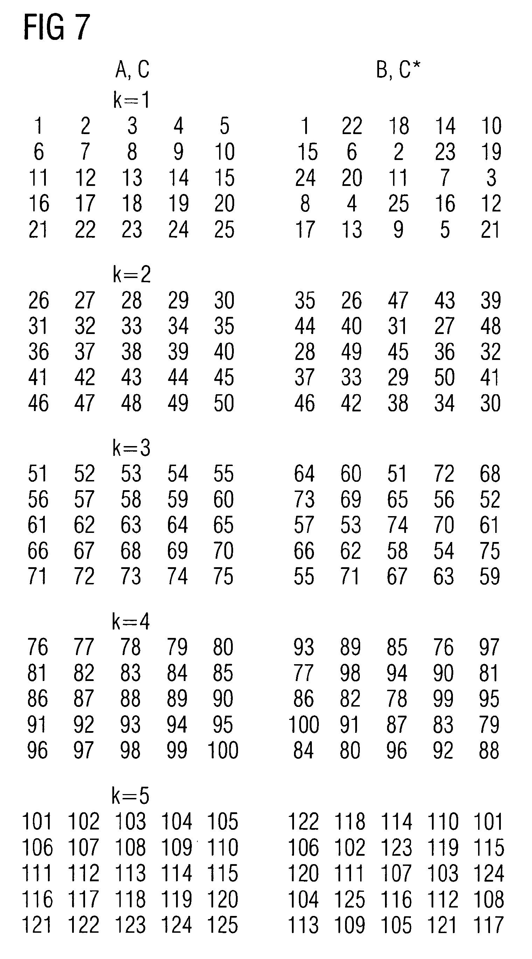

An efficient procedure is shown in table **figur 7**. In the first Xl-layer (k = 1) the positions of the elements in the columns 1 - 5 are shifted by 0, 1, 2, 3 and 4 positions. Than the positions in the rows 1 - 5 are shifted by 0, 1, 2, 3 and 4 positions.

In the next X2-layer (k = 2) the positions of the elements in the columns 1 - 5 are again shifted by 0, 1, 2, 3 and 4 positions but than the elements in all rows are shifted by 1, 2, 3, 4, 0 positions etc.

This corresponds with first shifting all Y-layers are by 0, 1, 2, 3, 4 positions according to fig. 6, than shifting the rows of the X-layers by different values and different for each X-layer.

After the complete interleaving every code vector (rows and colums) contains only one code element of the first code matrix.

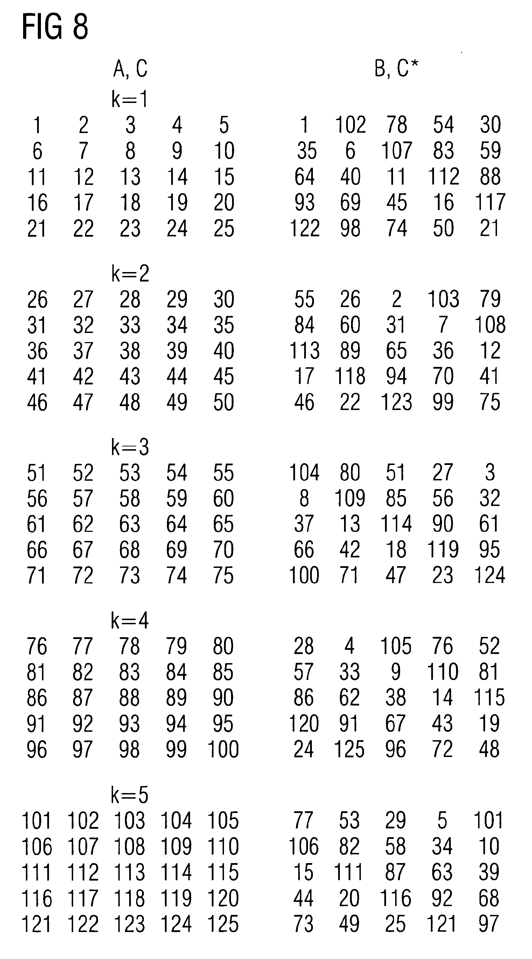

Another interleaving possibility is shown in **figure 8**. In a first interleaving step all the Y layers are shifted in the Y1 direction (figure 5) by 0 - 4 positions and than the i-rows rectangular to this Y-layers are shifted by 0 to 4 positions for the first new X-layer X1, 1 to 0 positions for the second X-layer X2 (modulo N, according to the number of shifted code elements), 2 to 1 positions for the third X-layer etc. After the complete interleaving every code vector again contains only one code element of the first code matrix. This interleaving is a good solution for burst errors because the adjacent bits of the A, C cube are separated very well.

Of course, the interleaving could start with every kind of layers to reach similar results. The sequence in with the code elements are transmitted must be taken into account for burst correction abilities. Also the sequence of shifting layers, or code elements by 0 - 4 positions (in the example) can by changed to a random sequence, but the shift procedure must be different for each layer, row or column.

## Claims

1. Method for improving error correction of concatenated codes comprising the steps of
storing information bits (aᵢⱼₖ), which form a cuboid information matrix (A = aᵢⱼₖ; i, j, k = 1, 2, ...n) , generating check bits (cᵢⱼₖ) of said cuboid information matrix (A) by an outer code to obtain first code vectors (V_{i,j}; V_{i,k}; V_{j,k}) , each first code vector (V_{i,j}; V_{i,k}; V_{j,k}) containing a string of the adjoining information bits (a_{i,j,f(k)}; a_{i,f(j),k}; a_{f(i),j,k}) and said check bits (C_{T} = c_{i,j,f(k)}; C_{C} = C_{i,f(j),k}; C_{R} ⁼ c_{f(i),j,k}),
the information matrix (A) and the check bits forming a code matrix (A, C),
cyclically interleaving the information bits (aᵢⱼₖ) and respectively the check bits (cᵢⱼₖ) to obtain an interleaved code matrix (B, C* = bᵢⱼₖ, c*ᵢⱼₖ) with second code vectors (Wᵢⱼ; Wᵢₖ; Wⱼₖ), whereby the second code vectors (Wᵢⱼ; Wᵢₖ; Wⱼₖ) of the interleaved code matrix (B, C* = bᵢⱼₖ, c*ᵢⱼₖ) contain only one information bit (aᵢⱼₖ) of each corresponding first code vector (V_{i,j}; V_{i,k}; V_{j,k}) and
coding the bits of the interleaved code matrix (B, C*) by an inner code,
where at least the outer code or the inner code is a three dimensional product code.

2. Method according to claim 1,
wherein the outer and the inner code are three dimensional product codes

3. Method according to claim 1 or 2,
wherein said stored information bits (aᵢⱼₖ) (i, j , k = 1,.2, ....5) form a cube information matrix (A).

4. Method according to claim 1, 2 or 3,
wherein the interleaving of the information bits (aᵢⱼₖ) and respectively the check bits (cᵢⱼₖ) comprises the steps of cyclically shifting said information bits in columns (j = 1, 2, ...) and in rows (i = 1,2, ...) by different values (0, 1, 2, ..., n) and different for each parallel layer (X1 - X5-layer: k= const. 1, 2, 3, 4, 5) having the same orientation of said interleaved code matrix (A, C) to obtain said interleaved code matrix (B, C* = bᵢⱼₖ, cᵢⱼₖ), whereby each second code vector (Wᵢⱼ; Wᵢₖ; Wⱼₖ) of the interleaved code matrix (B, C* = bᵢⱼₖ, cᵢⱼₖ) contains only one information bit (aᵢⱼₖ) of each corresponding first code vector (V_{i,j}; V_{i,k}; V_{j,k}).

5. Method according to claim 1, 2 or 3,
wherein the interleaving of the information bits (aᵢⱼₖ) and respectively the check bits (cᵢⱼₖ) comprises the steps of cyclically shifting said information bits (aᵢⱼₖ) and respectively the check bits (cᵢⱼₖ) for each parallel layer (j = const.1, 2, 3, 4, 5 or k = const.1, 2, 3, 4, 5) of said of said code matrix (A, C = aᵢⱼₖ, cᵢⱼₖ) having the same dimensions by different values (0, 1, 2, ..., n) to obtain a first code matrix and than shifting the rows or respectively columns of rectangular layers by different values and different for each rectangular layer - or vice versa - to obtain an interleaved code matrix (B, C* =bᵢⱼₖ, cᵢⱼₖ), whereby each second code vector (Wᵢⱼ; Wᵢₖ; Wⱼₖ) of the interleaved code matrix (B, C = bᵢⱼₖ, cᵢⱼₖ) contains only one information bit (aᵢⱼₖ) of each corresponding first code vector (V_{i,j}; V_{i,k}; V_{j,k})

6. Method according to claim 1 to 5,
wherein the number of shift positions is altered by 1 from a row to the next row - a column to the next column - a layer to the next layer.

7. Method according to one of the claims,
comprising the steps of decoding the interleaved code matrix by an inner code,
deinterleaving the code matrix and decoding the code matrix by an inner code.

8. Method according to claim 7,
using an iterative decoding procedure.
